# EUROPEAN PATENT SPECIFICATION

(11) **EP 4 687 355 B1**
(45) Date of publication and mention of the grant of the patent: **23.09.2026**
(21) Application number: 24191718.6
(22) Date of filing: 30.07.2024
(51) Int. Cl.: H04S 1/00, H04S 7/00, H03H 17/02, H04R 3/04

(54) **SYSTEM AND METHOD FOR OPERATING FIR FILTERS IN MULTI-CHANNEL AUDIO SYSTEMS**
SYSTEM UND VERFAHREN ZUM BETRIEB VON FIR-FILTERN IN MEHRKANAL-AUDIOSYSTEMEN
SYSTÈME ET PROCÉDÉ POUR FAIRE FONCTIONNER DES FILTRES FIR DANS DES SYSTÈMES AUDIO MULTICANAUX

(43) Date of publication of application: 04.02.2026
(73) Proprietor: Harman Becker Automotive Systems GmbH, 76307 Karlsbad (DE)
(72) Inventor: Kalinichenko, Victor, 85640 Putzbrunn (DE)
(74) Representative: Kraus & Lederer PartGmbB

(56) References cited:
- EP-B1- 0 894 362
- US-A1- 2007 052 556
- US-A1- 2021 194 463

## Description

### Technical Field

The present application relates to a system configured to process an audio signal and to the corresponding method for processing the audio signal by the system.

### Background

Signal flows in DSP (Digital Signal Processor) based audio applications, for example, in vehicle audio systems or in premium or high-end consumer electronics (like home-theater systems) may contain FIR (Finite Impulse Response)-filters. They may be used for various tasks: room equalization with keeping inter-channel phase shift unchanged; creating reverberations, which sound naturally; surround effects; creating immersion effects based on head-related transfer functions; creation multiple listening zones with individual sweet-spots, etc. Sometimes it is necessary to switch one set of coefficients of FIR-filters to another set of coefficients. This process is also known as *morphing.* Morphing may be needed, for example, in case the acoustical properties of the room have been changed, or in case another type of surround or reverberations is selected by user. Morphing by direct switching of coefficients of FIR-filters will cause transient effects at the output, which will be perceived by human as unpleasant plops, clicks or noises. Performing a smooth changing of FIR-coefficients from the initial state to the final state, using small steps, thus making the negative transient effects inaudible (or masked by the played back audio), should be made in the real-time task in order to prevent interruption of the coefficients update by the audio processing real-time task. This will lead to the short-time peak or even overload of the DSP for the entire duration of morphing, which usually take 20 - 1000 milliseconds, depending on length of the filter and preferences of the tuner. The DSP overload will lead to even worse noises at the output of the digital part of the audio system. To avoid DSP overload in this case (and thus, the audible noises during transient), one shall reserve extra real-time DSP processing power (usually known as MIPS = Mega Iteration Per Second). Reservation of the morphing dedicated MIPS makes utilizing the DSP inefficient and may lead to the need of using either more powerful DSP in order to meet all requirements of the audio system. Moreover, changing coefficients smoothly, using stepwise change of coefficients on every new audio frame (block of audio data), will require significant amount of additional memory. Typically, such a luxury is not available for DSP engineers implementing the algorithms.

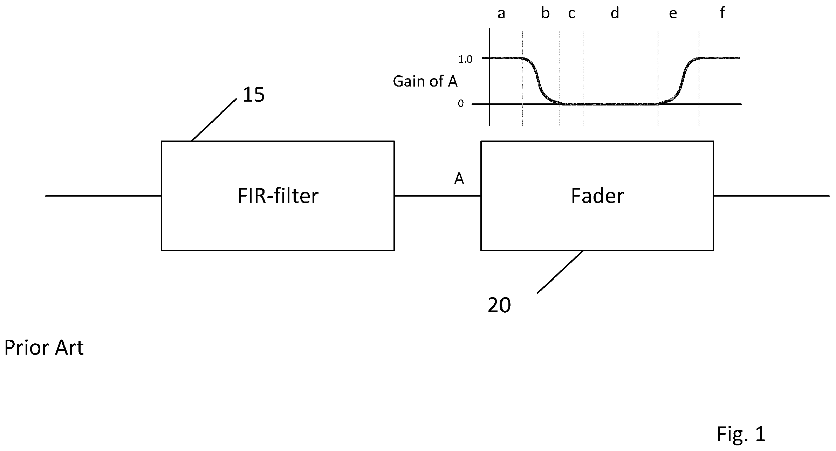

As shown in Fig. 1, in older audio systems comprising an FIR filter 15 and a fader 20, the audio outputs were temporarily muted for about 1-2 seconds using fading-out and fading-in of the gain for each channel. After the signal is faded out (Fig. 1, stage a), i.e. the gain is reduced to zero ("mute" state) in stage b, the coefficients of the FIR-filter are changed in one step (usually in non-real-time task), in stage c in Fig. 1. Then, there is a waiting time in order to let transient process to be finished (stage d in Fig. 1). This duration of this waiting time depends on the length of the FIR-filter for which the set of coefficients has just been changed. Waiting time shall be equal to or more than the length of the FIR-filter divided to the sampling frequency, which is for audio application either 44,100 kHz or 48,000 kHz. After that the fading-in process starts (stage e), which lets the output of the FIR-filter appear in stage f. This method has no unpleasant artefacts like noise, plops or clicks, but intermediate muting the signal makes is hardly acceptable nowadays.

Another method, which does not require intermediate muting, is described in US 11 239 828 B2. In this method a computationally cheap "Transition device" is used. Transition device can be one or two biquadratic filters or even a gain, which is working in parallel to the FIR-filter, for which the set of coefficients shall be changed. Transition device uses the same input signal as the FIR-filter. Its output is not used in normal conditions, i.e. the gain for the input as output by the transition device of the following mixer is set to zero. When FIR coefficients are to be replaced the gain of the main input at the mixer from the FIR filter is smoothly faded out (from 1.0 to 0.0) within a certain time, e.g. 10-20 msec with simultaneous smooth fading in of the of the input from the transition device. After gain at the input from the FIR filter reaches zero, the coefficient of the FIR-filter can be changed to the target values at once. Then the output of FIR filter is reactivated by simultaneously fading out of the gain for the input of the transition device and fading in of the gain for the FIR filter. This method works good in most applications. Although it does not cause any disruption or any severe unpleasant audible distortion, using computationally cheap transition device may cause in some cases a short-time disappearing of the effect produced by the FIR-filter. It can be especially noticeable if FIR-filters are long and used for creation surround or immersion effects. Furthermore an additional device is necessary which is only used when the filter coefficients are replaced and processing capacity has to be reserved for this extra device.

another method is known from US 2007/052556 A1, proposing a duplication of FIR filters and cross-fading between their outputs for allowing morphing of filter coefficients of one of the filters without generating audible artefacts.

Accordingly a need exists to overcome the above mentioned problems and to provide an option to replace FIR filter coefficients of an FIR filter in a way that the replacement is hardly noticed by a user when the sound is output by a sound system in which the FIR filter is used.

### Summary

This need is met by the features of the independent claims. Further aspects are described in the dependent claims.

According to a first aspect a system is provided configured to process an audio signal including a pair of two side specific audio channels wherein the system comprises two side specific mixing units, two side specific FIR filters and two morphing units. Each side specific mixing unit is configured to receive as input the two side specific audio channels of the pair and is configured to output a weighted mixed output signal mixed on the basis of the two side specific audio channels. Each of the side specific FIR filter is configured to receive as input the mixed output signal of the side specific mixing unit of the corresponding side and is configured to output a side specific filtered signal and each morphing unit is configured to receive as input the two side specific filtered signals of the two side specific FIR filters and to output a side specific morphed output signal. Each of the morphing units is configured, during a replacement period in which filter coefficients of one of the two side specific filters are to be replaced, to output, as a side specific morphed output signal, only the side specific filtered signal received as input from the other filter of the two side specific FIR filters.

Furthermore, the corresponding method is provided to process the audio signal by the system as discussed above or as discussed in further detail below. In a multichannel audio signal, the pair of side specific audio channels such as a left front channel and a right front channel or a left rear channel and right rear channel usually have similar frequency responses so that they are usually similar looking in frequency and time domains. Accordingly it is possible to feed both signals to one of the side specific FIR filters forming a kind of mono-channel formed using the side mixers and when this mixed output signal, the kind of mono-channel is temporarily used by one of the FIR filters, the filter coefficients of the other FIR filters can be replaced so that only one of the filters is used during the replacement. In this way FIR filter coefficients can be replaced in a way not noticeable to a user as a defect of the system (like in case of audible plops, clicks or noises), when the side specific morphed output signal is output by an audio system.

Other devices, systems, methods, features and advantages will be or will become apparent to one with skill in the art upon examination of the following detailed description when read in conjunction with the accompanying drawings in which like reference numerals refer to like elements.

### Brief description of the Drawings

Fig. 1 shows a schematic view of a system known in the art to replace FIR filter coefficients in an audio system.
Fig. 2 shows a schematic view of the system configured to provide a replacement of the filter coefficients of an FIR filter unnoticed to a user incorporating features of the invention.
Fig. 3 shows a schematic diagram of the gains applied to the different inputs shown in the system of Fig. 2.

### Detailed description

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are to be illustrative only. The drawings are to be regarded as being schematic representations, and elements illustrated in the drawings are not necessarily shown to scale. Rather, the various elements are represented such that their function and general purpose becomes apparent to a person skilled in the art. Any connection or coupling between functional blocks, devices, components of physical or functional units shown in the drawings and described hereinafter may also be implemented by an indirect connection or coupling. A coupling between components may be established over a wired or wireless connection. Functional blocks may be implemented in hardware, software, firmware, or a combination thereof.

In the following a system configured to process an audio signal is discussed which can process a multichannel audio system including side specific audio channels such as left or right channels. As will be discussed below it is possible for the left or right representation of the multichannel audio signal to use the FIR filter provided for one of the sides while the filter coefficients are replaced in the FIR filter of the other side and to feed a mixed signal mixed on the basis of the side specific audio channels to the FIR filter where the filter coefficients are currently not replaced. In the same way the FIR filtered output is then fed to 2 morphing units and each of the morphing units then uses the filtered output from the filter where the filter coefficients are currently not replaced.

It is a common situation for multichannel audio systems that most of the channels are coupled or paired meaning that there is a left front channel, a right front channel, a left rear channel, a right rear channel, a surround left channel and a surround right channel etc. The paired channels usually have similar frequency responses such as low cutoff and high cutoff frequency. By way of example, "front left" and "front right" channels means that the first channel is to be led to the loudspeaker located on the front left position in respect to the main seating position of the listener, while the second channel will be led to the loudspeaker located on the front right position, So pair of side specific channels means left or right relative to a main listening position. Accordingly they are usually similarly looking in frequency and time domains and as a consequence it is possible to feed to one of the FIR filters both inputs, the left and the right input. Accordingly, from the two side specific audio channels, the left and the right channel a mono-channel is formed and after this mono-channel passes through one of the FIR filters, one can temporarily use its output during the replacement of the coefficients of the other FIR filter to the new set of filter coefficients, for both, namely the left and the right output of the morphing unit.

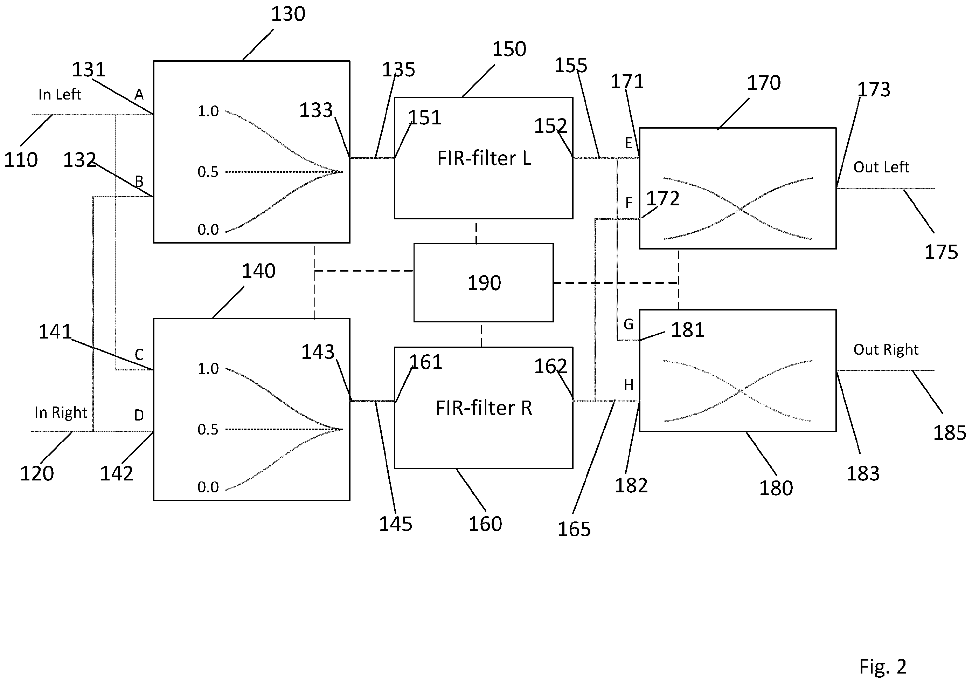

Fig. 2 shows a schematic view of a system with which the replacement of filter coefficients of an FIR filter can remain unnoticed by a user to which an audio signal is output passing through the system as shown in Fig. 2. The system comprises two side specific audio channels such as a left audio input channel 110 and a right audio input channel 120 wherein the system comprises for each of the sides a side specific mixing unit, a side specific FIR filter and a side specific morphing unit. Accordingly for the first or left side a first mixing unit 130 is provided, a first or left FIR filter 150 and a first or left morphing unit 170. In the same way, for the other side specific audio channel a signal processing chain is provided including a second or the right side mixing unit 140, the FIR filter 160 for the right side and the morphing unit 180 for the right side. The system has one output for each side such as the left side output signal 175 and the other side specific output, the right output signal 185. The signals 175 and 185 could be used for an output through a loudspeaker system also comprising side specific loudspeakers.

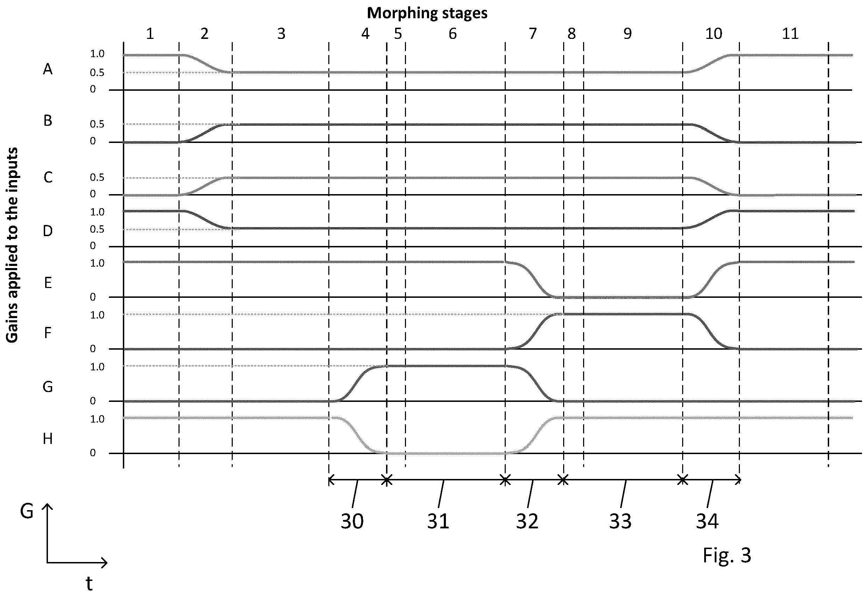

As shown in Fig. 2 each side specific audio channel 110 and 120 is fed to both mixing units so that each mixing unit 130 and 140 is able to generate a mixed output signal such as the left output signal 135 and the right output signal 145. Mixing unit 130 has two inputs 131 and 132 receiving input channels 110 and 120 respectively and in the same way mixing unit 140 has two inputs 141 and 142 receiving the audio channels 110 and 120 respectively, the inputs of mixing unit 130 are furthermore named input A and input B whereas the inputs for mixing unit 140 are named input C and input D. As discussed in connection with Fig. 3 characters A-D and E-H discussed later on will be used to show the gain applied to the different inputs. The single output 133 of mixing unit 130 is fed to the input 151 of the FIR filter 150 and in the same way the single output 143 of the mixing unit 140 provided for the other side, is fed to the input 161 of the corresponding filter unit 160. Accordingly, this means that each mixing unit is connected to only the FIR filter provided for the side specific audio channel of the same side, the mixing unit for the right side is only connected to the FIR filter for the right side and the mixing unit provided for the left side is only connected to the filter provided for the left channel audio signal. The mixed output signal 135 and 145 can be filtered by the corresponding filter units 150 and 160 respectively and a side specific filtered signal 155 and 165 is generated. As shown in Fig. 2 on the right-hand side the side specific filtered signal such as signal 155 and 165 is fed to both morphing units 170, 180, i.e. the morphing units of both sides. Accordingly, the filtered signal for the right side 165 is fed to the morphing unit 180 provided for the right side at its input 182 and is also fed to the left-hand morphing 170 at its input 172. In the same way, the filtered signal 155 for the left side audio channel is fed to the left side morphing unit 170 at its input 171 and in the same way it is fed to the right morphing unit 180 at its input 181 provided for the right channel. The inputs of the morphing units are also named from E to H in order to discuss the gain applied to the signals present at the corresponding input, as discussed in connection with Fig. 3 below.

In connection with Fig. 3 the mixing of the different audio signals and that the gain applied to the different inputs A-H are discussed. Fig. 3 discusses different stages or time periods of the FIR-morphing process and the gains applied at the different stages to the different inputs A-H shown in Fig. 2. In stage 1 the inputs of the left and right channel 110 and 120 are connected with the mixing units 130 and 140 as shown in Fig. 2 and under normal conditions without morphing in the system are just passed through the left and the right channels respectively. By way of example for input A the gain for the left input is 1 or 100 % while the other channel of the other side input at input B is not used and its gain is set to zero. In the same way mixing unit 140 only uses the input of its own side, the input B, while input C is set to zero. If it then becomes necessary to replace the coefficients of both filters 150 and 160 the mixing units can generate a mono-channel or can "monolize" the signals meaning that the gain of input A of mixing unit 130 will start smoothly decreasing from 100 down to 50 % while the gain of the input B will start a smooth increase from 0 to50 % (stage 2). Accordingly, during this process the sum of both gains A and B is kept at 1. In the same way the gain of input C will be increased from 0 to 50% while the gain at input D is smoothly decreased from 100 down to 50%. This is represented by stage 2 of Fig. 3. This means that the sound level or the sound pressure or energy during this mixing (i.e. during the entire stage 2) is not amended and the sound level is averaged. One can then wait until their outputs will be fully mixed meaning until the delay line of both FIR filters will be fully updated by the newly mixed samples. The duration of this waiting stage 3 can correspond to the length of the FIRs.

In the example Fig. 3 it is assumed that the filter coefficients of the right filter should be replaced first followed by a replacement of the filter coefficients of the left filter. In the next stage 4 the filtered signals of the left filter provided to the input of the morphing unit 180 is increased to 1 while the output of the right filter, the filtered signal 165 is smoothly decreased to 0 so that it is not used by the right morphing unit 180. Accordingly during the stage 4 both output signals 175 and 185 are becoming equal. Then the updating of the coefficients of the right filter 160 can be started. Summarizing, during stage 4 the coefficient of the input G at morphing unit 180 is morphed from 0 to 1 while simultaneously its input H is morphed from 1 to 0. As a consequence, the "monolized" output of the left FIR filter 150 is used for the right channel output during the replacement of the coefficients of the right filter 160. At a stage 5 the changing of the coefficients of the right FIR filter 160 is carried out. As the output 162 of the filter 160 is in fact not used during the stage 5, the coefficients of the filter 160 can be replaced either in real-time or in non-real-time task. Following stage 5, the replacement stage or period, a waiting cycle is introduced in stage 6 which can again correspond to the length of the right filter 160 needs to finish the transient process at its output caused by changing its coefficients. After that the output of the right FIR filter can be used again. Accordingly, in stage 7 for the right morphing unit 180 the input G is morphed from 1 to 0 while the input H, the output received from the same side is morphed from 0 to 1 meaning that morphing unit 180, after stage 7, again outputs the filtered signal as generated by the FIR filter 160 of the same side. Now the replacement of the coefficients of the left FIR filter 150 can be done after having fed the output 173 by the output of the right FIR filter 160, thus applying the output 162 to both outputs 173 and 183. To this end one can start simultaneously a smooth inverting of the gains for all inputs for morphing unit 170 meaning that for the left morphing unit 170 the filtered output of the left filter 150 (input E) is smoothly being changed from 1 to 0 while the output of the other filter, the input F is simultaneously being changed from 0 to 1. After that it is again safe to replace the filter coefficients of the left FIR filter 150 in stage 8 followed again by a waiting cycle in stage 9 to let the transient process within the filter be finished.

As shown by the gains of inputs A-D, during this replacement period the mixing at the input side at inputs A, B, C and D is continuing. At stage 10 is possible to "demonolize" all inputs of both filters returning the coefficients for inputs A and D to 1 while decreasing the gains for inputs B and C from 50 down to0%. This process can be carried out in parallel with the simultaneous smooth changing of the output of the left filter E to the intended output. Furthermore the inputs at E and F are smoothly inverted so that morphing unit 170 again is able to let pass different filtered output of the corresponding side while the input F from the filter of the other side is decreased to 0. In stage 11 the process is over and the system works as in the first stage 1.

Returning to Fig. 2 a control unit 190 may be provided connected to all the entities involved which can control the gains present at the inputs A-H as shown in Fig. 3 and as discussed above. The control unit 190 can be implemented as a kind of state machine and from a technical point of view this state machine could be implemented as part of code of the FIR filters 150 and 160. Accordingly the control unit 190 can be a separate unit or can be logically integrated in one of the other units such as the filters 150 and 160.

Referring again to Fig. 3 stage 5, the replacement period and the waiting period (stages 4 and 5) could be identified as changing period 31 for one of the filters wherein a first transition period precedes this changing period, the first transition period 30. The same way a second transition period 32 is succeeding the changing period 31 or the waiting stage 6. In the same way a changing period 33 is provided for the second filter which includes the replacement stage or period 8 and the waiting period 9. Transition period 34 follows the second changing period 33.

In transition period 34 the whole system changes back to the gain as present before the morphing process starts, thus to the status in stage 1.

For the second filter replacement the transition period 32 for one filter placed the transition period also for the other filter preceding the changing period 33, followed by another transition period 34 where the system moves again to the original state. As can be seen the changing period 31 does not overlap with the changing period 33. This means that the replacement period or stage 5 does not overlap with the replacement period or stage 8 for the other filter. Accordingly the filter coefficients for the two filters are not replaced during the same period but one after the other.

During the stage 7, where both morphing units 170 and 180 are operating, each performing cross-morphing (E vs F and G vs H) the following relations between the gains shall be kept for each time moment to ensure that the sound levels in both channels are not varying during the period 32: gain of E plus gain of F shall be equal to 1; gain of G plus gain of H shall be equal to 1; sum of the gains E, F, G and H shall be equal to 2.

Stages 1-11 for all pairs of FIR-filters can be carried out in parallel. For example, stages 1-11 for the channels pair "front-left" - "front-right" can be carried out in parallel with the stages 1-11 for the pair "rear-left" - "rear-right".

For non-paired channels like a center channel or a subwoofer channel it is possible to use a muting for them during the morphing within simultaneous increase of some gains in order to compensate the temporary lack of the sound intensity during their muting. By way of example for compensating a muting of the center channel, it is possible to increase the front left and front right channels by approximately 1-3 dB. If an FIR filter is used in the subwoofer channel, no compensation may be needed, because it can be muted for a short period of time needed for replacing the coefficients followed by a waiting cycle which will not be noticed by a user. If compensation gains should be applied, it can be done by using the gains of inputs A-D above 0.5 during the muting of the non-paired channel.

When the whole procedure is considered from the point of view of the control unit 190, the latter can be responsible for the coordination of the different entities involved, if not each or any of the other entities is controlling the coordination of the different entities . The control unit can be a separate entity or it can be implemented in one or several of the entities shown in Fig. 2.

The control unit 190:
- receives the process / the command or event to initiate the procedure of replacement of coefficients of FIR filters (150, 160) in at least one pair of side specific FIR filters,
- initiates stage 2, i.e. forms and sends to both mixing units (130, 140) the commands to start transition to the replacement operating mode;
- initiates stage 3, i.e. after having received the confirmation that the transition to the replacement operating mode is finished, or after a pre-defined period of time, for which the transition to the replacement operating mode is assumed to have been finished, initiates a waiting cycle, where the delay lines of both FIR filters of the paired side channels are assumed to be fully updated by the mixed signals;
- initiates stage 4, i.e. after waiting cycle is finished, forms and sends the command to one of the morphing units to start the cross-morphing process, where the gain of the side specific input is being smoothly morphed from 1 to 0, while the gain of the other input, for which the signal from the opposite side of the pair of two paired side specific channels is fed, is being morphed from 0 to 1, thus temporary stopping using the output of the FIR filter of the corresponding side;
- initiates stage 5, i.e. after having received the confirmation that the transition period of one of the morphing units, for which the transition had been initiated on the previous stage, is finished, or after a pre-defined period of time, for which the morphing process in the above mentioned morphing unit is assumed to have been finished, forms and sends the command to the FIR-filter, for which the output has been stopped to be used, to replace the coefficients;
- initiates stage 6, i.e. after having received the confirmation that the coefficients of the FIR filter mentioned in the previous stage have been replaced, or after a pre-defined period of time, for which the coefficients of this FIR filter are assumed to have been replaced, initiates a waiting cycle, where the delay line of the FIR filter, for which the coefficients have been replaced during the previous stage, has to be fully updated;
- initiates stage 7, i.e. after the waiting cycle mentioned in the previous stage is over:
   - forms and sends the command to the morphing unit of the side specific channel, for which the coefficients of the corresponding FIR filter have just been replaced, to start the reverse cross-morphing process, where the gain of the side specific input is being smoothly morphed from 0 to 1, while the gain of the other input, for which the signal from the opposite side of the pair of two paired side specific channels is fed, is being morphed from 1 to 0, thus deactivating the mode where the output of the FIR filter, for which the coefficients have just been replaced, is not used, thus, starting outputting the output of this FIR filter to the specific output of the corresponding side;
   - forms and sends the command to the other morphing unit in the pair of the side specific channels, for which the coefficients of the corresponding FIR filter have not yet been replaced, to start the cross-morphing process, where the gain of the side specific input is being smoothly morphed from 1 to 0, while the gain of the other input, for which the signal from the opposite side of the pair of two paired side specific channels is fed, is being morphed from 0 to 1, thus temporary stopping using the output of the FIR filter of the corresponding side, for which the coefficients have not yet been replaced;
- initiates stage 8, i.e. after having received the confirmation that the transition period of the morphing unit, which has stopped using the output of the FIR filter in the paired side specific channels, for which the coefficients have not yet been replaced, is finished, or after a pre-defined period of time, for which the morphing process in the above mentioned morphing unit is assumed to have been finished, forms and sends the command to the FIR-filter, for which the output has been stopped to be used, to replace the coefficients;
- initiates stage 9, i.e. after having received the confirmation that the coefficients of the FIR filter mentioned in the previous stage have been replaced, or after a pre-defined period of time, for which the coefficients of this FIR filter are assumed to have been replaced, initiates a waiting cycle, where the delay line of the FIR filter, for which the coefficients have been replaced during the previous stage, has to be fully updated;
- initiates stage 10, i.e. after the waiting cycle mentioned in the previous stage is over:
   - forms and sends the command to the morphing unit of the side specific channel, for which the coefficients of the corresponding FIR filter have just been replaced, to start the reverse cross-morphing process, where the gain of the side specific input is being smoothly morphed from 0 to 1, while the gain of the other input, for which the signal from the opposite side of the pair of two paired side specific channels is fed, is being morphed from 1 to 0, thus deactivating the mode where the output of the FIR filter, for which the coefficients have just been replaced, is not used, thus, starting outputting the output of this FIR filter to the output of the corresponding side;
   - forms and sends the command to both mixing units to deactivate mixing mode, where the "monolized" signals are applied to both FIR filters, i.e. to smoothly morph the gain for the input A from 0.5 to 1 and the gain for the input B - from 0.5 to 0; and to smoothly morph the gain for the input C from 0.5 to 0 and the gain for the input D - from 0.5 to 1;
- initiates stage 11, i.e. after having received the confirmation that the transition periods of the both mixing units, which have been activated in the previous stage, have been finished, or after a pre-defined period of time, for which the morphing process in the mixing units which have been activated in the previous stage, have been finished are assumed to have been finished, initiates a waiting cycle, where the delay lines of the FIR filters in the pair, for which the coefficients have been replaced, are fully updated;
- after the waiting time from the previous stage is over, possibly forms and sends notification command informing other devices and units belonging to the audio system that the coefficients of both FIR filters in the pair have been successfully replaced and both FIR filters are used in the normal operating mode.

From the above said some general conclusions can be drawn.

Each side specific mixing unit such as mixing unit 130 and 140 can generate the mixed output signal 135 and 145 such that a sound level of the pair of side specific audio channels is averaged. This could obtained in the example discussed above by using both input signals but with a 50% decrease in gain. In the morphing units 170 and 180, during a changing period such as period 31 and 33 of Fig. 3 which includes the replacement period 5 or 8 and which also includes the waiting period 6 and 9 respectively in which the replacement of the filter coefficients is completed, the morphing unit is outputting as side specific morphed output signal only the side specific filtered signal received as input from the other FIR filter. Accordingly when the filter coefficients for the right filter 160 are replaced the morphing units 170 and 180 use during this time the input as received from the left FIR filter 150 and vice versa.

Here it is possible that the first morphing unit from the two morphing units provided for the same side as the FIR filter where the filter coefficients are replaced, can change the gain for the side specific filtered signal received as input from the FIR filter where the filter coefficients are replaced from 100 to 0 % and the first morphing unit can then change the gain for the side specific filtered signal received as input from the other FIR filter from 0 to 100 %. As discussed in connection with Fig. 2 when the right filter coefficients of filter 160 are replaced, the morphing unit increases the gain for input G from 0 to 100 % while decreasing the gain for the input H of the filter 160 from 1 to 0. Furthermore, the same morphing unit, such as morphing unit 180 during the replacement of the right filter coefficients at filter 160 can, in a second transition period 32, change the gain for the side specific filtered signal received as input from the FIR filter where the filter coefficients are replaced from 0 to 100 % and change the gain for the side specific filtered signal received as input for the other filter from 100 to 0 %. This corresponds to the gain transition in period 32 for inputs G and H.

The replacement period such as the replacement periods or stages 5 and 8 can include a first side replacement period 5 for one of the two filters and a second side replacement period 8 for the other filter and the two side specific filters are configured such that the first side replacement period has no overlap in time with the second side replacement period. Furthermore, the changing period provided for each of the morphing units such as periods 31 and 33 shown in Fig. 3 can be configured such that the changing period for one of the morphing units has no overlap with the changing period for the other of the morphing units.

Furthermore, it is possible that outside the changing period and the at least one transition period each morphing unit is to output only the side specific morphed output signal received as input from the filter provided at the corresponding side. Accordingly, outside the changing period 31 and the transition period 30 and 32 morphing unit 180 will use the signal as received from filter 160 as shown by input H and in the same way as shown for input E morphing unit 170 will use outside the periods 32-34 only the output as received from the filter of the same side.

Side specific audio channels can comprise a left audio channel and a right audio channel such as channels 110 and 120, the mixing units can comprise a left mixing unit 130 and the right mixing 140 and the side specific filter can include a left FIR filter 150 and a right FIR filter 160. In the same way the two morphing units can include a left morphing unit 170 and right morphing unit 180. Left and right in the present context should mean that they are provided for the corresponding side specific audio channel so left filter left morphing unit or left mixing unit means that it is the filter provided for the left audio channel and in the same way right mixer right filter or right morphing unit means that it is provided for the right side audio channel. Here it shall be mentioned that using the classification words "left" and "right" as two variants of side specific channels is not strictly bounded to the actual left and actual right side audio. It can also be front and back channels. We keep the side channel classifiers as "left" and "right" also for these and similar cases, where the two channels containing FIR filters to be morphed are logically bounded and, thus, can be jointly used in morphing their FIR filters.

The system can include a control unit configured to coordinate an operation of the two side specific mixing units 130, 140, the two side specific finite impulse response, FIR, filters 150, 160, and the two morphing units 170, 180, as discussed above. The control unit can be configured to initiate the replacement of the filter coefficients at both side specific FIR filters such that the replacement period of the first of the two FIR filters does not overlap with the replacement period of the second of the two FIR filters. Furthermore, the control unit can be configured initiate a start of the first and second transition period for the first morphing unit. However it should be understood that the control unit need not to be provided, the coordination of the timing of the different entities can be implemented in any of the entities involved and shown in Fig. 2.

As discussed above a possibility is provided which is free of unpleasant artefacts when filter coefficients in an FIR filter are replaced in a multichannel audio system.

## Claims

1. A system configured to process an audio signal including a pair of two side specific audio channels (110, 120), the system comprising two side specific mixing units (130, 140), two side specific finite impulse response, FIR, filters (150, 160), and two morphing units (170, 180), wherein:
- each side specific mixing unit (130, 140), is configured to receive as input the two side specific audio channels (110, 120) of the pair and to output a mixed output signal (135, 145) mixed on a basis of the two side specific audio channels,
- each side specific FIR filter (150, 160) is configured to receive as input the mixed output signal of the side specific mixing unit of the corresponding side, and to output a side specific filtered signal (155, 165),
- each morphing unit is configured to receive as input the two side specific filtered signals of the two side specific FIR filters, and to output a side specific morphed output signal (175, 185), wherein each of the morphing units is configured, during a replacement period (5, 8), during which filter coefficients of one of the two side specific FIR filters are replaced, to output, as side specific morphed output signal, only the side specific filtered signal received as input from the other filter of the two side specific FIR filters.

2. The system of claim 1, wherein each side specific mixing unit (130, 140) is configured to generate the mixed output signal such that a sound level of the pair of side specific audio channels is averaged.

3. The system of claim 1 or 2, wherein each morphing unit (170, 180), during a changing period (31, 33) including the replacement period (5,8) and a waiting period (6,9) in which the replacement of the filter coefficients is completed in the system and which follows the replacement period, is configured to output, as side specific morphed output signal, only the side specific filtered signal received as input from the other FIR filter, for which the coefficients are not being changed.

4. The system of claim 3, wherein a first morphing unit from the 2 morphing units provided for the same side as the FIR filter where the filter coefficients are replaced, is configured, during a first transition period (30) preceding the replacement period (5), to change a gain for the side specific filtered signal received as input received from the FIR filter, where the filter coefficients are to be replaced, from 100 % to 0 %, and to change the gain for the side specific filtered signal received as input from the other FIR filter from 0% to 100 %.

5. The system of claim 4, wherein the first morphing unit is configured, in a second transition period (32) following the changing period (31) to change a gain for the side specific filtered signal received as input received from the FIR filter, where the filter coefficients have been replaced, from 0% to 100 % again, and to change the gain for the side specific filtered signal received as input from the other FIR filter, where the coefficients are to be replaced, from 100 % to 0 %.

6. The system of any preceding claim, wherein the replacement period comprises a first side replacement period (5) for one of the two side specific FIR filters and a second side replacement period (8) for the other of the two side specific FIR filters, wherein the two side specific FIR filters are configured such that the first side replacement period has no overlap with the second side replacement period.

7. The system of any of claims 3 to 6, wherein the changing period (31, 33) is provided for each of the morphing units, and the 2 morphing units are configured such that the changing period (31) for one of the two morphing units has no overlap with the changing period (33) of the other of the 2 morphing units.

8. The system of any of claims 4 to 7, wherein outside the changing period and the at least one transition period, each morphing unit is configured to output only the side specific morphed output signal received as input from the FIR filter provided for the corresponding side.

9. The system of any preceding claim, wherein the side specific audio channel 110, 120) comprises a left audio channel and a right audio channel, the two side specific mixing units comprise a left mixing unit provided for the left audio channel and a right mixing unit provided for the right audio channel, the two side specific FIR filters comprise a left FIR filter for the left audio channel and a right FIR filter for the right audio channel, and the 2 morphing units comprise a left morphing unit for the left audio channel and a right morphing unit for the right audio channel.

10. The system of any preceding claim, wherein each side specific mixing unit (130, 140) is configured to operate in a normal operating mode where the output signal corresponds to the input signal of the side specific audio channel of the corresponding side, and to operate in a replacement operating mode where the mixed output signal is output, wherein the mixed output signal is only output in the replacement operating mode and not in the normal operating mode.

11. The system of claim 10, wherein each side specific mixing unit is configured to operate in the replacement operating mode during both changing periods and the transition periods .

12. The system of any preceding claim further comprising a control unit configured to coordinate an operation of the two side specific mixing units (130, 140), the two side specific finite impulse response, FIR, filters (150, 160), and the two morphing units (170, 180), as claimed in any of claims 1 to 11.

13. The system of claim 12, wherein the control unit is configured to initiate the replacement of the filter coefficients at both side specific FIR filters such that the replacement period of the first of the two FIR filters does not overlap with the replacement period of the second of the two FIR filters.

14. The system of claim 5 and 12 or 13, wherein the control unit is configured initiate a start of the first and second transition period for the first morphing unit.

15. A method for processing, by a system, an audio signal including a pair of two side specific audio channels, the system comprising two side specific mixing units, two side specific finite impulse response, FIR, filters, and two morphing units, the method comprising:
- receiving, at each side specific mixing unit as input the two side specific audio channels of the pair and outputting a mixed output signal mixed from the two side specific audio channels,
- receiving, at each side specific finite impulse response, FIR, filter, as input the mixed output signal of the side specific mixing unit of the corresponding side, and output a side specific filtered signal,
- receiving, at each morphing unit, as input the two side specific filtered signals of the two side specific FIR filters, and outputting a side specific morphed output signal, wherein each of the morphing units, during a replacement period, during which filter coefficients of one of the two side specific FIR filters are being replaced, outputs, as side specific morphed output signal, only the side specific filtered signal received as input from the other FIR filter.

## Patentansprüche

1. System, das konfiguriert ist, um ein Audiosignal zu verarbeiten, das ein Paar von zwei seitenspezifischen Audiokanälen (110, 120) einschließt, wobei das System zwei seitenspezifische Mischeinheiten (130, 140), zwei seitenspezifische Filter mit endlicher Impulsantwort, FIR, (150, 160) und zwei Morphing-Einheiten (170, 180) umfasst, wobei:
- jede seitenspezifische Mischeinheit (130, 140) konfiguriert ist, um als Eingang die zwei seitenspezifischen Audiokanäle (110, 120) des Paares zu empfangen und ein gemischtes Ausgangssignal (135, 145) auszugeben, das auf einer Basis der zwei seitenspezifischen Audiokanäle gemischt wird,
- jeder seitenspezifische FIR-Filter (150, 160) konfiguriert ist, um als Eingang das gemischte Ausgangssignal der seitenspezifischen Mischeinheit der entsprechenden Seite zu empfangen und ein seitenspezifisches gefiltertes Signal (155, 165) auszugeben,
- jede Morphing-Einheit konfiguriert ist, um als Eingang die zwei seitenspezifischen gefilterten Signale der zwei seitenspezifischen FIR-Filter zu empfangen und ein seitenspezifisches Morphing-Ausgangssignal (175, 185) auszugeben, wobei jede der Morphing-Einheiten konfiguriert ist, um während einer Austauschperiode (5, 8), während der Filterkoeffizienten von einem von den zwei seitenspezifischen FIR-Filter ausgetauscht werden, als seitenspezifisches Morphing-Ausgangssignal nur das seitenspezifische gefilterte Signal auszugeben, das als Eingang von dem anderen Filter der zwei seitenspezifischen FIR-Filter empfangen wird.

2. System nach Anspruch 1, wobei jede seitenspezifische Mischeinheit (130, 140) konfiguriert ist, um das gemischte Ausgangssignal derart zu erzeugen, dass ein Schallpegel des Paares seitenspezifischer Audiokanäle gemittelt wird.

3. System nach Anspruch 1 oder 2, wobei jede Morphing-Einheit (170, 180) während einer Änderungsperiode (31, 33), die die Austauschperiode (5, 8) und eine Warteperiode (6, 9) einschließt, in der der Austausch der Filterkoeffizienten in dem System abgeschlossen wird und die auf die Austauschperiode folgt, konfiguriert ist, um als seitenspezifisches Morphing-Ausgangssignal nur das seitenspezifische gefilterte Signal auszugeben, das als Eingang von dem anderen FIR-Filter empfangen wird, für den die Koeffizienten nicht geändert werden.

4. System nach Anspruch 3, wobei eine erste Morphing-Einheit aus den 2 Morphing-Einheiten, die für dieselbe Seite wie der FIR-Filter bereitgestellt ist, bei dem die Filterkoeffizienten ausgetauscht werden, konfiguriert ist, um während einer ersten Übergangsperiode (30), die der Austauschperiode (5) vorausgeht, eine Verstärkung für das seitenspezifische gefilterte Signal, das als Eingang von dem FIR-Filter empfangen wird, bei dem die Filterkoeffizienten ausgetauscht werden sollen, von 100 % auf 0 % zu ändern und die Verstärkung für das seitenspezifische gefilterte Signal, das als Eingang von dem anderen FIR-Filter empfangen wird, von 0 % auf 100 % zu ändern.

5. System nach Anspruch 4, wobei die erste Morphing-Einheit konfiguriert ist, um in einer zweiten Übergangsperiode (32), die auf die Änderungsperiode (31) folgt, eine Verstärkung für das seitenspezifische gefilterte Signal, das als Eingang von dem FIR-Filter empfangen wird, bei dem die Filterkoeffizienten ausgetauscht worden sind, wieder von 0 % auf 100 % zu ändern und die Verstärkung für das seitenspezifische gefilterte Signal, das als Eingang von dem anderen FIR-Filter empfangen wird, bei dem die Koeffizienten ausgetauscht werden sollen, von 100 % auf 0 % zu ändern.

6. System nach einem der vorhergehenden Ansprüche, wobei die Austauschperiode eine erste Seitenaustauschperiode (5) für einen von den zwei seitenspezifischen FIR-Filtern und eine zweite Seitenaustauschperiode (8) für den anderen der zwei seitenspezifischen FIR-Filter umfasst, wobei die zwei seitenspezifischen FIR-Filter derart konfiguriert sind, dass die erste Seitenaustauschperiode keine Überlappung mit der zweiten Seitenaustauschperiode aufweist.

7. System nach einem der Ansprüche 3 bis 6, wobei die Änderungsperiode (31, 33) für jede der Morphing-Einheiten bereitgestellt ist und die 2 Morphing-Einheiten derart konfiguriert sind, dass die Änderungsperiode (31) für eine der zwei Morphing-Einheiten keine Überlappung mit der Änderungsperiode (33) der anderen der 2 Morphing-Einheiten aufweist.

8. System nach einem der Ansprüche 4 bis 7, wobei außerhalb der Änderungsperiode und der mindestens einen Übergangsperiode jede Morphing-Einheit konfiguriert ist, um nur das seitenspezifische Morphing-Ausgangssignal auszugeben, das als Eingang von dem FIR-Filter empfangen wird, der für die entsprechende Seite bereitgestellt ist.

9. System nach einem der vorhergehenden Ansprüche, wobei der seitenspezifische Audiokanal (110, 120) einen linken Audiokanal und einen rechten Audiokanal umfasst, die zwei seitenspezifischen Mischeinheiten eine linke Mischeinheit, die für den linken Audiokanal bereitgestellt ist, und eine rechte Mischeinheit, die für den rechten Audiokanal bereitgestellt ist, umfassen, die zwei seitenspezifischen FIR-Filter einen linken FIR-Filter für den linken Audiokanal und einen rechten FIR-Filter für den rechten Audiokanal umfassen und die 2 Morphing-Einheiten eine linke Morphing-Einheit für den linken Audiokanal und eine rechte Morphing-Einheit für den rechten Audiokanal umfassen.

10. System nach einem der vorhergehenden Ansprüche, wobei jede seitenspezifische Mischeinheit (130, 140) konfiguriert ist, um in einem normalen Betriebsmodus zu arbeiten, in dem das Ausgangssignal dem Eingangssignal des seitenspezifischen Audiokanals der entsprechenden Seite entspricht, und um in einem Austauschbetriebsmodus zu arbeiten, in dem das gemischte Ausgangssignal ausgegeben wird, wobei das gemischte Ausgangssignal nur in dem Austauschbetriebsmodus und nicht in dem normalen Betriebsmodus ausgegeben wird.

11. System nach Anspruch 10, wobei jede seitenspezifische Mischeinheit konfiguriert ist, um sowohl während der Änderungsperioden als auch während der Übergangsperioden in dem Austauschbetriebsmodus zu arbeiten.

12. System nach einem der vorhergehenden Ansprüche, ferner umfassend eine Steuereinheit, die konfiguriert ist, um einen Betrieb der zwei seitenspezifischen Mischeinheiten (130, 140), der zwei seitenspezifischen Filter mit endlicher Impulsantwort, FIR, (150, 160) und der zwei Morphing-Einheiten (170, 180) zu koordinieren, wie nach einem der Ansprüche 1 bis 11 beansprucht.

13. System nach Anspruch 12, wobei die Steuereinheit konfiguriert ist, um den Austausch der Filterkoeffizienten an beiden seitenspezifischen FIR-Filtern derart einzuleiten, dass sich die Austauschperiode des ersten der zwei FIR-Filter nicht mit der Austauschperiode des zweiten der zwei FIR-Filter überschneidet.

14. System nach Anspruch 5 und 12 oder 13, wobei die Steuereinheit konfiguriert ist, um einen Beginn der ersten und der zweiten Übergangsperiode für die erste Morphing-Einheit einzuleiten.

15. Verfahren zum Verarbeiten eines Audiosignals, das Audiosignal ein Paar von zwei seitenspezifischen Audiokanälen einschließt, durch ein System, wobei das System zwei seitenspezifische Mischeinheiten, zwei seitenspezifische Filter mit endlicher Impulsantwort, FIR, und zwei Morphing-Einheiten umfasst, wobei das Verfahren Folgendes umfasst:
- Empfangen, an jeder seitenspezifischen Mischeinheit, der zwei seitenspezifischen Audiokanäle des Paares als Eingang und Ausgeben eines gemischten Ausgangssignals, das aus den zwei seitenspezifischen Audiokanälen gemischt wird,
- Empfangen, an jedem seitenspezifischen Filter mit endlicher Impulsantwort, FIR, des gemischten Ausgangssignals der seitenspezifischen Mischeinheit der entsprechenden Seite als Eingang und Ausgeben eines seitenspezifischen gefilterten Signals,
- Empfangen, an jeder Morphing-Einheit, der zwei seitenspezifischen gefilterten Signale der zwei seitenspezifischen FIR-Filter als Eingang und Ausgeben eines seitenspezifischen Morphing-Ausgangssignals, wobei jede der Morphing-Einheiten während einer Austauschperiode, während der Filterkoeffizienten von einem der zwei seitenspezifischen FIR-Filter ausgetauscht werden, als seitenspezifisches Morphing-Ausgangssignal nur das seitenspezifische gefilterte Signal ausgibt, das als Eingang von dem anderen FIR-Filter empfangen wird.

## Revendications

1. Système configuré pour traiter un signal audio comportant une paire de canaux audio spécifiques à chaque côté (110, 120), le système comprenant deux unités de mixage spécifiques à chaque côté (130, 140), deux filtres à réponse impulsionnelle finie, FIR, spécifiques à chaque côté (150, 160) et deux unités de morphing (170, 180), dans lequel :
- chaque unité de mixage spécifique à chaque côté (130, 140) est configurée pour recevoir en entrée les deux canaux audio spécifiques à chaque côté (110, 120) de la paire et pour produire un signal de sortie mixé (135, 145) sur la base des deux canaux audio spécifiques à chaque côté,
- chaque filtre FIR spécifique à un côté (150, 160) est configuré pour recevoir en entrée le signal de sortie mixte de l'unité de mixage spécifique à un côté et pour produire un signal filtré spécifique à un côté (155, 165),
- chaque unité de morphing est configurée pour recevoir en entrée les deux signaux filtrés spécifiques à chaque côté des deux filtres FIR spécifiques à chaque côté, et pour produire un signal de sortie morphé spécifique à chaque côté (175, 185), dans lequel chacune des unités de morphing est configurée, pendant une période de remplacement (5, 8), au cours de laquelle les coefficients de filtrage de l'un des deux filtres FIR spécifiques à chaque côté sont remplacés, pour produire, en tant que signal de sortie morphé spécifique à chaque côté, uniquement le signal filtré spécifique à chaque côté reçu en entrée de l'autre filtre des deux filtres FIR spécifiques à chaque côté.

2. Système selon la revendication 1, dans lequel chaque unité de mixage spécifique à un côté (130, 140) est configurée pour générer le signal de sortie mixé de telle sorte qu'un niveau sonore de la paire de canaux audio spécifiques à un côté soit moyenné.

3. Système selon la revendication 1 ou 2, dans lequel chaque unité de morphing (170, 180), pendant une période de changement (31, 33) comportant la période de remplacement (5,8) et une période d'attente (6,9) au cours de laquelle le remplacement des coefficients du filtre est terminé dans le système et qui suit la période de remplacement, est configurée pour produire, en tant que signal de sortie morphé spécifique au côté, uniquement le signal filtré spécifique au côté reçu en entrée de l'autre filtre FIR, pour lequel les coefficients ne sont pas modifiés.

4. Système selon la revendication 3, dans lequel une première unité de morphing parmi les 2 unités de morphing prévues pour le même côté que le filtre FIR où les coefficients du filtre sont remplacés, est configurée, pendant une première période de transition (30) précédant la période de remplacement (5), pour modifier le gain du signal filtré spécifique au côté reçu en entrée du filtre FIR, où les coefficients du filtre doivent être remplacés, de 100 % à 0 %, et pour modifier le gain du signal filtré spécifique au côté reçu en entrée de l'autre filtre FIR de 0 % à 100 %.

5. Système selon la revendication 4, dans lequel la première unité de morphing est configurée, dans une seconde période de transition (32) suivant la période de changement (31), pour modifier le gain du signal filtré spécifique au côté reçu en entrée du filtre FIR, où les coefficients du filtre ont été remplacés, de 0 % à 100 %, et pour modifier le gain du signal filtré spécifique au côté reçu en entrée de l'autre filtre FIR, où les coefficients doivent être remplacés, de 100 % à 0 %.

6. Système selon une quelconque revendication précédente, dans lequel la période de remplacement comprend une première période de remplacement latérale (5) pour l'un des deux filtres FIR spécifiques à un côté et une seconde période de remplacement latérale (8) pour l'autre des deux filtres FIR spécifiques à un côté, dans lequel les deux filtres FIR spécifiques à un côté sont configurés de telle sorte que la première période de remplacement latérale ne chevauche pas la seconde période de remplacement latérale.

7. Système selon l'une quelconque des revendications 3 à 6, dans lequel la période de changement (31, 33) est prévue pour chacune des unités de morphing, et les 2 unités de morphing sont configurées de telle sorte que la période de changement (31) de l'une des deux unités de morphing ne chevauche pas la période de changement (33) de l'autre des 2 unités de morphing.

8. Système selon l'une quelconque des revendications 4 à 7, dans lequel, en dehors de la période de changement et d'au moins une période de transition, chaque unité de morphing est configurée pour ne produire que le signal de sortie morphé spécifique au côté reçu en entrée du filtre FIR prévu pour le côté correspondant.

9. Système selon une quelconque revendication précédente, dans lequel le canal audio spécifique au côté (110, 120) comprend un canal audio gauche et un canal audio droit, les deux unités de mixage spécifiques au côté comprennent une unité de mixage gauche prévue pour le canal audio gauche et une unité de mixage droite prévue pour le canal audio droit, les deux filtres FIR spécifiques au côté comprennent un filtre FIR gauche pour le canal audio gauche et un filtre FIR droit pour le canal audio droit, et les 2 unités de morphing comprennent une unité de morphing gauche pour le canal audio gauche et une unité de morphing droite pour le canal audio droit.

10. Système selon une quelconque revendication précédente, dans lequel chaque unité de mixage spécifique à un côté (130, 140) est configurée pour fonctionner en mode de fonctionnement normal où le signal de sortie correspond au signal d'entrée du canal audio spécifique à un côté du côté correspondant, et pour fonctionner en mode de fonctionnement de remplacement où le signal de sortie mixé est émis, dans lequel le signal de sortie mixé n'est émis qu'en mode de fonctionnement de remplacement et non en mode de fonctionnement normal.

11. Système selon la revendication 10, dans lequel chaque unité de mixage spécifique à un côté est configurée pour fonctionner en mode de fonctionnement de remplacement pendant les périodes de changement et les périodes de transition.

12. Système selon une quelconque revendication précédente comprenant en outre une unité de commande configurée pour coordonner le fonctionnement des deux unités de mélange spécifiques à chaque côté (130, 140), des deux filtres à réponse impulsionnelle finie, FIR, spécifiques à chaque côté (150, 160) et des deux unités de morphing (170, 180), comme revendiqué dans l'une quelconque des revendications 1 à 11.

13. Système selon la revendication 12, dans lequel l'unité de commande est configurée pour initier le remplacement des coefficients de filtre des deux filtres FIR spécifiques de côté de sorte que la période de remplacement du premier des deux filtres FIR ne chevauche pas la période de remplacement du second des deux filtres FIR.

14. Système selon la revendication 5 et 12 ou 13, dans lequel l'unité de commande est configurée pour initier le démarrage de la première et de la seconde période de transition pour la première unité de morphing.

15. Procédé de traitement, par un système, d'un signal audio comportant une paire de canaux audio spécifiques à chaque canal, le système comprenant deux unités de mixage spécifiques à chaque canal, deux filtres à réponse impulsionnelle finie, FIR spécifiques à chaque canal et deux unités de morphing, le procédé comprenant :
- la réception, au niveau de chaque unité de mixage spécifique, en entrée de deux canaux audio spécifiques de chaque côté de la paire et la production d'un signal de sortie mixé à partir des deux canaux audio spécifiques de chaque côté,
- la réception, de chaque côté, d'un filtre à réponse impulsionnelle finie spécifique, FIR, en entrée le signal de sortie mixte de l'unité de mélange spécifique du côté correspondant, et en sortie un signal filtré spécifique au côté,
- la réception, de chaque unité de morphing, en entrée de deux signaux filtrés spécifiques à chaque côté des deux filtres FIR spécifiques à chaque côté, et la production d'un signal de sortie morphé spécifique à chaque côté, dans lequel chacune des unités de morphing est configurée, pendant une période de remplacement, au cours de laquelle les coefficients de filtrage de l'un des deux filtres FIR spécifiques à chaque côté sont remplacés, pour produire, en tant que signal de sortie morphé spécifique à chaque côté, uniquement le signal filtré spécifique à chaque côté reçu en entrée de l'autre filtre des deux filtres FIR spécifiques à chaque côté.
